(19) Europäisches Patentamt
European Patent Office
Office européen des brevets

(11) **EP 1 187 142 B1**

(12) **FASCICULE DE BREVET EUROPEEN**

(45) Date de publication et mention
de la délivrance du brevet:
**19.11.2003 Bulletin 2003/47**

(51) Int Cl.⁷: **G11C 15/04**

(21) Numéro de dépôt: **01410110.9**

(22) Date de dépôt: **03.09.2001**

(54) **Cellule cache à masquage avec un nombre égal de transistors à canal N et de transistors à canal P**

Zwischenspeicherzelle mit Maskierung und gleicher Anzahl von N-Kanal Transistoren und P-Kanal Transistoren

Cache cell with mask and equal number of N-channel transistors and P-channel transistors

(84) Etats contractants désignés:
**DE FR GB IT**

(30) Priorité: **04.09.2000 FR 0011242**

(43) Date de publication de la demande:
**13.03.2002 Bulletin 2002/11**

(73) Titulaire: **STMicroelectronics S.A.**
**92120 Montrouge (FR)**

(72) Inventeur: **Ferrant, Richard**
**38920 Crolles (FR)**

(74) Mandataire: **de Beaumont, Michel**
**Cabinet Michel de Beaumont**
**1, rue Champollion**
**38000 Grenoble (FR)**

(56) Documents cités:
**DE-A- 19 839 205        US-A- 6 044 005**

• **PATENT ABSTRACTS OF JAPAN vol. 013, no. 537 (P-968), 30 novembre 1989 (1989-11-30) & JP 01 220293 A (NEC CORP), 1 septembre 1989 (1989-09-01)**
• **PATENT ABSTRACTS OF JAPAN vol. 1996, no. 05, 31 mai 1996 (1996-05-31) & JP 08 007580 A (HITACHI LTD), 12 janvier 1996 (1996-01-12)**

## Description

La présente invention concerne une cellule d'un réseau de mémoire cache, couramment désignée dans la technique par le sigle CAM, d'après l'expression anglo-saxonne Content Addressed Memory, et plus particulièrement une telle cellule munie d'un élément de masquage.

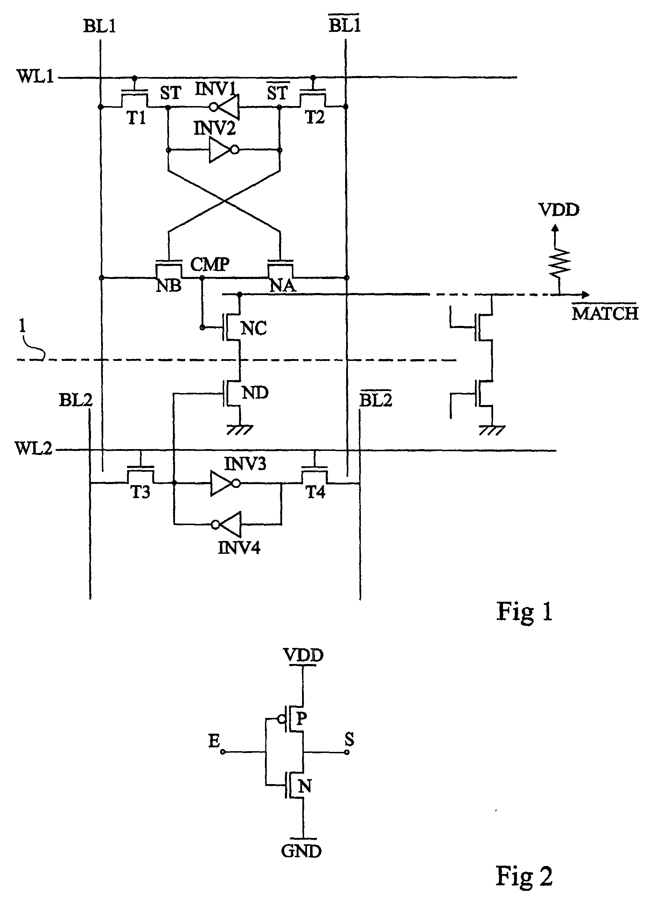

La figure 1 représente une cellule cache classique au-dessus du trait mixte 1. Cette cellule est associée à deux lignes de bit complémentaires BL1 et $\overline{BL1}$, représentées verticalement, à une ligne de mot WL1 représentée horizontalement, et à une ligne de résultat $\overline{MATCH}$ représentée horizontalement. Les lignes de bit sont communes à des colonnes de cellules, et les lignes de mot et de résultat sont communes à des rangées de cellules.

La cellule cache comprend un élément de mémorisation et un élément de comparaison.

L'élément de mémorisation comprend, entre les lignes BL1 et $\overline{BL1}$, la connexion en série d'un transistor MOS T1, de deux inverseurs en anti-parallèles INV1 et INV2 et d'un transistor MOS T2. Les grilles des transistors T1 et T2 sont reliées à la ligne de mot WL1. Pour mémoriser un état, on met un 1 sur la ligne de mot WL1. Les deux transistors T1 et T2 sont alors passants et les points ST et $\overline{ST}$ situés de part et autre des inverseurs prennent, respectivement, les états existants sur les lignes BL1 et $\overline{BL1}$. La ligne de mot WL1 est ensuite remise à zéro, les transistors T1 et T2 sont bloqués, et l'état des points ST et $\overline{ST}$ est mémorisé.

L'élément de comparaison comprend deux transistors MOS NB et NA en série entre les lignes BL1 et $\overline{BL1}$. Le point de connexion CMP de ces deux transistors est connecté à la grille d'un transistor NC connecté entre une ligne de résultat $\overline{MATCH}$ et la masse. Pendant une étape de comparaison, la ligne WL1 est maintenue à zéro, et les lignes BL1 et $\overline{BL1}$ sont mises dans l'état que l'on veut comparer à l'état préalablement mémorisé. On voit que, si l'on reproduit sur les lignes BL1 et $\overline{BL1}$ l'état qui a été mémorisé, le point CMP est à niveau bas (0) et le transistor NC est bloqué. L'état de la ligne de résultat $\overline{MATCH}$ (qui est maintenu à une tension haute Vdd par une résistance ou tout autre moyen de mise à niveau haut) n'est donc pas modifié. En fait, comme la ligne $\overline{MATCH}$ est reliée à toutes les cellules d'une même rangée, on vérifie ainsi qu'un mot à comparer est identique ou non à un mot précédent. Par contre, si un bit d'un mot à comparer diffère du bit correspondant du mot mémorisé, le point CMP de la cellule correspondante passe à niveau haut, le transistor NC correspondant devient passant et la ligne $\overline{MATCH}$ change d'état et passe à zéro.

La figure 1 représente, en dessous d'une ligne en traits mixtes 1, des éléments de circuit permettant d'inhiber ("masquer") une cellule. En effet, on veut pouvoir comparer des mots dont certains bits sont indifférents. Pour atteindre ce résultat, on prévoit un transistor supplémentaire ND entre le transistor NC et la masse. Ce transistor ND est rendu constamment passant quand on veut effectivement valider la comparaison de la cellule concernée et est rendue constamment ouvert quand on veut inhiber la comparaison. En effet, dans ce dernier cas, quel que soit l'état du transistor NC, la connexion vers la masse de la ligne de résultat $\overline{MATCH}$ pour la cellule concernée est constamment ouverte. Pour la commande du transistor ND, il est prévu une cellule de mémorisation comprenant des transistors T3 et T4 et des inverseurs INV3 et INV4, similaires aux composants de l'élément de mémorisation précédemment décrit de la cellule cache mais disposés entre des lignes de bit BL2 et $\overline{BL2}$ et associés à une ligne de mots WL2.

Comme cela est représenté en figure 2, un inverseur comprend deux transistors MOS complémentaires en série entre une source de tension haute VDD et la masse GND, l'entrée E de l'inverseur correspondant aux grilles communes de ces transistors et la sortie S de l'inverseur correspondant à la borne commune des deux transistors. Ainsi, le circuit de la figure 1 comprend 16 transistors MOS : 12 transistors à canal N et 4 transistors à canal P.

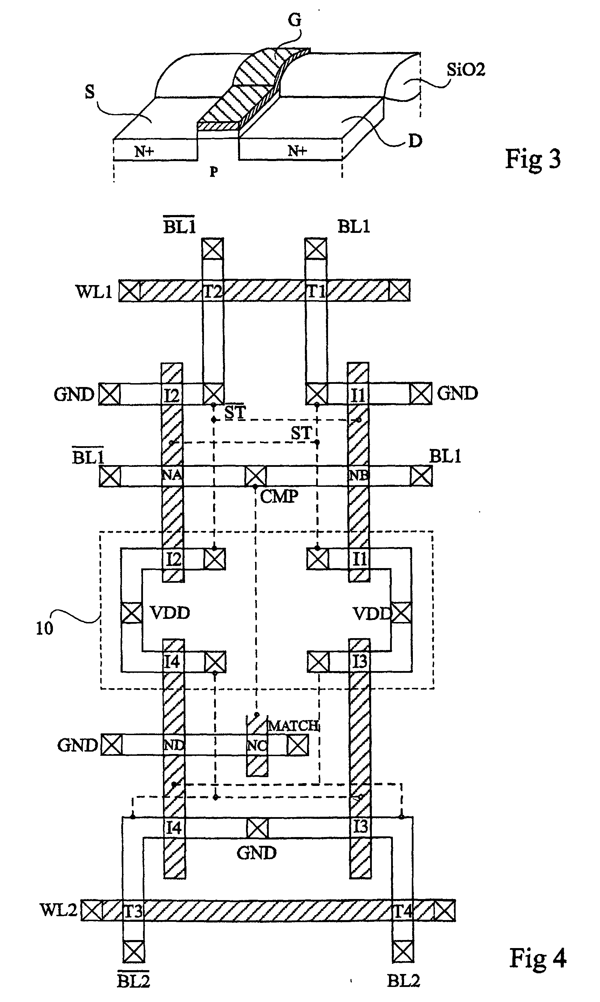

La figure 3 rappelle très schématiquement l'allure d'un transistor MOS élémentaire. Ce transistor comprend de part et d'autre d'une grille G des régions de source et de drain fortement dopées d'un premier type de conductivité et formées dans un substrat du type de conductivité opposé. Les zones actives sont séparées les unes des autres par des régions d'oxyde épais ($SiO_2$). Le transistor de la figure 3 est un transistor à canal N. Les transistors à canal P ont une structure similaire, tous les types de conductivité étant inversés. Ceci signifie qu'ils sont formés dans un substrat ou un caisson de type N. Les caissons N dans lesquels sont formés les transistors à canal P doivent être à une distance non négligeable de la limite des transistors de type N les plus proches. Ceci amène à regrouper tous les transistors de type P dans un caisson commun.

La figure 4 représente en vue de dessus un exemple de réalisation sous forme de circuit intégré du circuit de la figure 1. Tous les transistors de type P, c'est-à-dire les transistors à canal P des inverseurs INV1 à INV4 sont regroupés dans un même caisson 10.

La figure 4 est extrêmement schématique. Les zones actives des transistors sont représentées par des rectangles blancs. Les couches de silicium polycristallin qui constituent des grilles aux emplacements où elles coupent les zones actives sont hachurées. La référence de chaque transistor est représentée à l'emplacement où la grille de ce transistor recouvre sa zone active. Les zones de contact avec les diverses régions sont marquées d'une croix. Les connexions entre bornes de transistors, quand elles ne sont pas assurées par une prolongation d'une zone active, sont indiquées par des traits en pointillés. Dans la pratique, ces connexions seront assurées par l'un ou l'autre de divers niveaux de métallisations formés sur le circuit intégré. Les deux transistors d'un même inverseur INV sont désignés par une même référence I. Par exemple, les transistors à canal N et canal P de l'inverseur INV2 sont tous deux désignés par la référence I2, étant entendu que le transistor désigné par la référence I2 disposé dans le caisson 10 est un transistor à canal P et que le transistor désigné par la référence I2 externe au caisson 10 est un transistor à canal N.

Comme l'illustre la figure 4, les transistors T1 et T2, les transistors à canal N I1 et I2 des inverseurs INV1 et INV2, et les transistors NA et NB sont disposés en haut de la figure, au-dessus du caisson 10. Les transistors NC et ND, les transistors à canal N I3 et I4, des inverseurs INV3, INV4, et les transistors T3 et T4 sont disposés en bas de la figure, au-dessous du caisson 10. Cette disposition correspond à une optimisation du circuit résultant de nombreuses améliorations effectuées par des concepteurs spécialisés.

L'expérience montre que, par exemple dans une filière telle que la filière HCMOS8 de la société STMicroelectronics, dans laquelle la dimension minimum d'un motif est de 0,18 $\mu$m, on arrive à une structure d'une surface de 23,5 $\mu$m$^2$. Avec une filière de type HCMOS9 dans laquelle la dimension minimum d'un motif est de 0,12 $\mu$m, on arrive à une surface de 12 $\mu$m$^2$. Ces surfaces ne sont pas compressibles en raison des distances de garde minimum à conserver entre les différents composants et les métallisations qui les relient. On notera en particulier que l'un des facteurs qui contribue beaucoup à la surface d'un circuit intégré résulte de la prévision d'aires de liaison ou plots de connexion à partir desquels on fera croître des vias et sur lesquels on pourra réaliser une connexion avec des métallisations.

L'objet de la présente invention est de prévoir un circuit de mémoire cache avec masquage qui puisse être réalisé sous forme de circuit intégré avec une surface plus faible que les circuits de l'art antérieur.

Pour atteindre cet objet, la présente invention prévoit essentiellement de modifier le circuit de l'art antérieur de façon qu'il comprenne un nombre égal de transistors à canal N et de transistors P. Ainsi, la présente invention prévoit de maintenir des transistors à canal N pour les transistors des cellules de mémorisation et de prévoir des transistors à canal P pour les autres transistors.

Plus particulièrement, la présente invention prévoit une cellule cache à masquage réalisée sous forme de circuit intégré, comprenant une première cellule de mémorisation disposée entre deux premières lignes de bit, et comprenant, en série, un premier transistor, des premier et deuxième inverseurs en anti-parallèle et un deuxième transistor, les grilles des premier et deuxième transistors étant connectées à une première ligne de mot ; une cellule de comparaison, comprenant des troisième et quatrième transistors disposés entre les premières lignes de bit, le point de connexion des troisième et quatrième transistors commandant un cinquième transistor, connecté en série avec un sixième transistor d'inhibition entre une ligne de résultat et une tension de polarisation ; et une deuxième cellule de mémorisation, comprenant entre des deuxièmes lignes de bit un septième transistor en série avec deux inverseurs en anti-parallèle et un huitième transistor, la deuxième cellule de mémorisation commandant le transistor d'inhibition. Une telle cellule à masquage réalisée sous forme de circuit intégré est connue du document JP 1220293 A. Selon l'invention, les premier, deuxième, septième, et huitième transistors sont des transistors à canal d'un premier type et les troisième, quatrième, cinquième et sixième transistors sont des transistors à canal de type opposé.

Selon un mode de réalisation de la présente invention, les transistors à canal de type opposé sont des transistors à canal P et sont réalisés dans un même caisson N.

Selon un mode de réalisation de la présente invention, les premier, deuxième, septième et huitième transistors sont réalisés de façon sensiblement alignée, de même que les transistors à canal N des inverseurs, et les transistors à canal P sont réalisés de façon sensiblement alignée de même que les transistors à canal P des inverseurs.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 représente une cellule de mémoire cache à masquage classique ;
la figure 2 représente les connexions d'un inverseur ;
la figure 3 représente une vue en perspective schématique et partielle d'un transistor MOS à canal N ;
la figure 4 représente une vue de dessus d'une réalisation sous forme de circuit intégré du circuit de la figure 1 ;
la figure 5 représente un schéma de cellule de mémoire cache avec masquage selon la présente invention ;
la figure 6 représente une vue de dessus d'un circuit intégré mettant en oeuvre le circuit de la figure 5 ; et
les figures 7A et 7B représentent des assemblages de cellules selon l'art antérieur et selon la présente invention, pour mieux faire ressortir les avantages de la présente invention.

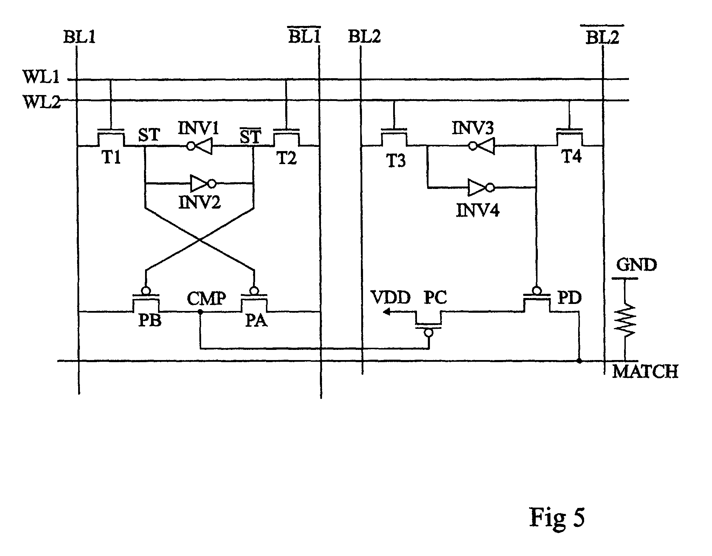

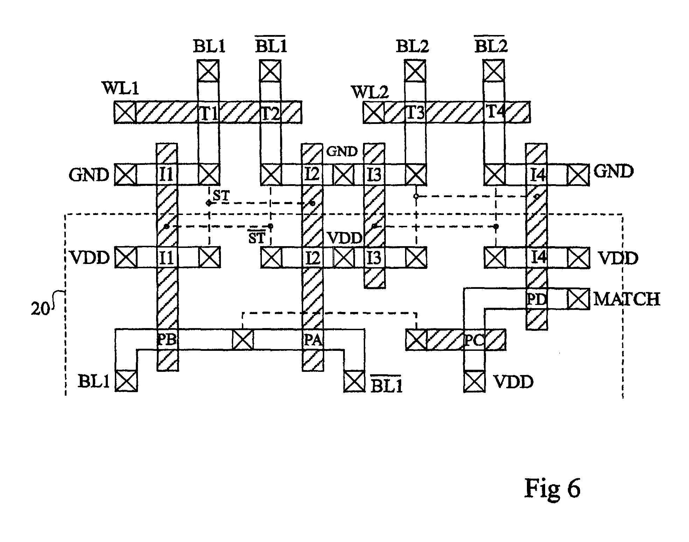

La figure 5 représente un schéma d'un circuit de cellule de cache avec masquage selon la présente invention. Dans ce schéma, les transistors sont représentés autant que possible au voisinage des emplacements auxquels ils seront réalisés dans un circuit intégré comme cela est décrit ci-après en relation avec la figure 6.

En figure 5, les transistors T1 et T2 et les inverseurs INV1 et INV2 sont montés comme précédemment entre des lignes de bit BL1 et $\overline{BL1}$, et les grilles des transistors T1 et T2 sont connectées à une ligne de mot WL1. Les transistors T3, T4 et les inverseurs INV3, INV4 sont connectés comme précédemment entre des lignes de bit BL2 et $\overline{BL2}$ et les grilles des transistors sont connectées à une ligne de mot WL2. Toutefois, dans cette figure, la deuxième cellule de mémorisation est représentée à côté de la première et non pas en dessous comme dans le cas de la figure 1. Les transistors MOS à canal N NA et NB de la figure 1, connectés entre les lignes BL1 et $\overline{BL1}$, sont remplacés par des transistors MOS à canal P PA et PB. Le point de connexion CMP est connecté à un transistor MOS à canal P PC au lieu du transistor MOS à canal N NC. Le transistor MOS à canal P PC est connecté en série avec un transistor MOS à canal P PD entre la tension de référence Vdd et une ligne de résultat MATCH. La ligne de résultat est désignée par l'appellation MATCH et non pas $\overline{MATCH}$ comme dans le cas de la figure 1 étant donné que le résultat est inversé par rapport au cas de la figure 1. En figure 1, une concordance se traduisait par le fait que la ligne $\overline{MATCH}$ était à 1. Maintenant, une concordance se manifeste par le fait que la ligne MATCH est à 0.

La figure 6 représente une vue de dessus schématique et simplifiée d'une réalisation sous forme de circuit intégré du circuit de la figure 5. On a utilisé dans cette figure le même type de représentation qu'en figure 4.

Ce circuit comprend un nombre égal (8) de transistors NPN et PNP. Tous les transistors à canal P sont disposés dans un même caisson N désigné dans la figure par la référence 20.

Dans le caisson N 20 sont prévus les transistors à canal P I1 à I4 des inverseurs INV1 à INV4 ainsi que les transistors PA, PB, PC et PD.

Dans le substrat P sont prévus les transistors à canal N I1 à I4 des inverseurs INV1 à INV4 et les transistors T1 à T4 des cellules de mémorisation.

En examinant la figure 6, on voit immédiatement que sa structure est plus compacte que celle de la figure 4 notamment du fait que les longueurs de connexion sont réduites et que de nombreux croisements de connexion sont évités. En particulier, la connexion entre le point de raccordement CMP des transistors PA et PB et la grille du transistor PC se fait entre des composants voisins situés tous deux dans le caisson N des transistors à canal P alors que, dans le schéma de la figure 4, la connexion correspondante entre le point de raccordement CMP des transistors NA et NB et la grille du transistor NC se faisait en traversant tout le caisson N, ce qui obligeait à prévoir des distances de garde non négligeables.

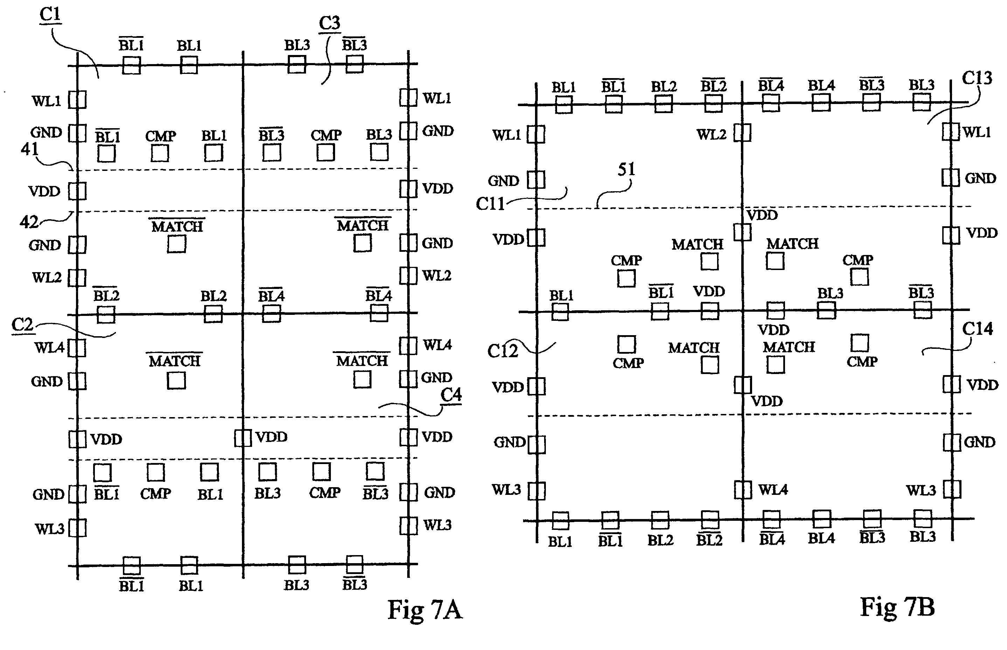

D'autres avantages de la présente invention seront indiqués en relation avec les figures 7A et 7B. La figure 7A représente un assemblage de quatre cellules C1, C2, C3, C4 dont chacune correspond à la structure de l'art antérieur illustrée en figure 4. La figure 7B représente un assemblage de quatre cellules C11, C12, C13, C14 dont chacune correspond à la structure selon l'invention illustrée en figure 6.

De ces figures ressortent deux avantages supplémentaires de la présente invention à savoir d'une part une réduction du nombre de plots, d'autre part une réduction du nombre de séparations entre le caisson N et substrat ou caisson N et caisson P.

Dans les figures 7A et 7B, on a représenté des plots internes aux cellules et des plots situés à la périphérie des cellules et partagés avec des cellules voisines. Il est clair que si l'on augmente le nombre de plots partagés entre cellules voisines, on réduit la dimension puisque l'on divise par deux le nombre de plots correspondants. Cette réduction de dimension est notable étant donné que chaque plot occupe une surface non négligeable sur la structure. On note plus particulièrement que les plots BL1 et $\overline{BL1}$ internes aux cellules C1 et C2, de même que les plots BL3 et $\overline{BL3}$ internes aux cellules C3 et C4, ne se retrouvent pas dans les cellules C11, C12 et C13, C14. En figure 7B, ces plots sont disposés aux limites entre deux cellules voisines. Leur nombre est donc divisé par deux.

Selon un autre avantage de la présente invention, on limite le nombre de frontières entre caissons N, dans lesquels sont réalisés les transistors à canal P, et substrat (ou caissons P) dans lequel sont réalisés les transistors à canal N. Comme le montre la figure 7A, dans la structure de l'art antérieur, les caissons N peuvent s'étendre selon une rangée de cellules et comportent deux frontières 41 et 42 de part et d'autre de chaque extension dans une rangée de cellules. Selon la présente invention, étant donné que les caissons N occupent la moitié d'une cellule et se prolongent dans la moitié de la cellule sous-jacente, le nombre de frontières 51 s'étendant selon une rangée de cellules est divisé par deux par rapport à l'art antérieur. Ceci aussi entraîne une réduction importante de dimensions des cellules étant donné qu'il faut prendre des précautions particulières à la frontière entre une région N et une région P.

Bien entendu, la présente invention est susceptible de diverses variantes et modifications qui apparaîtront à l'homme de l'art. Notamment diverses optimisations pourront être réalisées selon la technologie de fabrication utilisée.

**Revendications**

1. Cellule cache à masquage réalisée sous forme de circuit intégré, comprenant :

   une première cellule de mémorisation disposée entre deux premières lignes de bit (BL1, $\overline{BL1}$), et comprenant, en série, un premier transistor (T1), des premier et deuxième inverseurs (INV1, INV2) en anti-parallèle et un deuxième transistor (T2), les grilles des premier et deuxième transistors étant connectées à une première ligne de mot (WL1) ;

une cellule de comparaison, comprenant des troisième et quatrième transistors (PA, PB) disposés entre les premières lignes de bit (BL1, $\overline{BL1}$), le point de connexion (CMP) des troisième et quatrième transistors commandant un cinquième transistor (PC), connecté en série avec un sixième transistor d'inhibition (PD) entre une ligne de résultat (MATCH) et une tension de polarisation (Vdd) ;

une deuxième cellule de mémorisation, comprenant entre des deuxièmes lignes de bit (BL2, $\overline{BL2}$) un septième transistor (T3) en série avec deux inverseurs (INV3, INV4) en anti-parallèle et un huitième transistor (T4), la deuxième cellule de mémorisation commandant le transistor d'inhibition (PD) ;

**caractérisée en ce que** les premier, deuxième, septième, et huitième transistors sont des transistors à canal d'un premier type et les troisième, quatrième, cinquième et sixième transistors sont des transistors à canal de type opposé.

**2.** Cellule selon la revendication 1, dans laquelle lesdits transistors à canal de type opposé sont des transistors à canal P et sont réalisés dans un même caisson N occupant sensiblement une moitié de la surface d'une cellule.

**3.** Cellule selon la revendication 2, **caractérisée en ce que** les premier (T1), deuxième (T2), septième (T3) et huitième (T4) transistors sont réalisés de façon sensiblement alignée, de même que les transistors à canal N des inverseurs, et **en ce que** les transistors à canal P (PA, PB, PC, PD) sont réalisés de façon sensiblement alignée de même que les transistors à canal P (I1 à I4) des inverseurs.

**Patentansprüche**

**1.** Eine CAM-Zelle mit einer Maskierung, die in der Form einer integrierten Schaltung hergestellt ist, beinhaltend:

eine erste Speicherzelle, die zwischen zwei ersten Bitleitungen (BL1, $\overline{BL1}$) angeordnet ist, und welche in Reihe einen ersten Transistor (T1), erste und zweite Wechselrichter (INV 1, INV2) in antiparalleler Anordnung und einen zweiten Transistor (T2) beinhaltet, wobei die gates der ersten und zweiten Transistoren mit einer ersten Wortleitung (WL1) verbunden sind;

eine Vergleichszelle, die einen dritten und einen vierten Transistor (PA, PB) beinhaltet, die zwischen den ersten Bitleitungen (BL1, $\overline{BL1}$) angeordnet sind, wobei der Verbindungspunkt (CMP) des dritten und des vierten Transistors, welche einen fünften Transistor (PC) steuern, in Reihe mit einem sechsten sperrenden Transistor (PD) zwischen einer Ergebnisleitung (MATCH) und einer Vorspannung (Vdd) angeschlossen ist;

eine zweite Speicherzelle, die zwischen zweiten Bitleitungen (BL2, $\overline{BL2}$) einen siebten Transistor (T3) in Reihe mit zwei Wechselrichtern (INV3, INV4) in antiparalleler Anordnung und einen achten Transistor (T4) beinhaltet, wobei die zweite Speicherzelle den sperrenden Transistor (PD) steuert;

**dadurch gekennzeichnet, daß**

der erste, zweite, siebente und achte Transistor Transistoren mit einem Kanal eines ersten Typs sind, und der dritte, vierte, fünfte und sechste Transistor Transistoren mit einem Kanal des entgegengesetzten Typs sind.

**2.** Zelle nach Anspruch 1, **dadurch gekennzeichnet, daß** die Transistoren mit einem Kanal des entgegengesetzten Typs P-Kanal-Transistoren sind und in einer selben N-Senke gebildet sind.

**3.** Zelle nach Anspruch 2, **dadurch gekennzeichnet, daß** der erste (T1), zweite (T2), siebte (T3) und achte Transistor (T4) sowie die N-Kanal-Transistoren der Wechselrichter in einer im wesentlichen ausgerichteten Weise gebildet sind und die P-Kanal-Transistoren (PA, PB, PC, PD) sowie die P-Kanal-Transistoren (I1 bis I4) der Wechselrichter in einer im wesentlichen ausgerichteten Weise gebildet sind.

**Claims**

**1.** A CAM cell with masking made in the form of an integrated circuit, including:

a first storage cell arranged between two first bit lines (BL1, $\overline{BL1}$), and including, in series, a first transistor (T1), first and second inverters (INV1, INV2) in anti-parallel, and a second transistor (T2), the gates of the first and second transistors being connected to a first word line (WL1);

a comparison cell, including third and fourth transistors (PA, PB) arranged between the first bit lines (BL1, $\overline{BL1}$), the connection point (CMP) of the third and fourth transistors controlling a fifth transistor (PC), connected in series with a sixth inhibiting transistor (PD) between a result line (MATCH) and a bias voltage (Vdd);

a second storage cell, including between second bit lines (BL2, $\overline{BL2}$) a seventh transistor (T3) in series with two inverters (INV3, INV4) in anti-parallel and an eighth transistor (T4), the second storage cell controlling the inhibiting transistor (PD);

**characterized in that** the first, second, seventh, and eighth transistors are transistors having a channel of a first type, and the third, fourth, fifth, and sixth transistors are transistors with a channel of the opposite type.

2. The cell of claim 1, **characterized in that** the transistors having a channel of opposite type are P-channel transistors and are formed in a same N well.

3. The cell of claim 2, **characterized in that** the first (T1), second (T2), seventh (T3), and eighth transistors (T4), as well as the N-channel transistors of the inverters, are formed in a substantially aligned way and the P-channel transistors (PA, PB, PC, PD), as well as the P-channel transistors (I1 to I4) of the inverters, are formed in a substantially aligned way.

Fig 1

Fig 2

G

S

SiO2

N+

N+

D

P

**Fig 3**

$\overline{BL1}$

BL1

WL1

T2

T1

GND

I2

$\overline{ST}$

I1

GND

ST

$\overline{BL1}$

BL1

NA

NB

CMP

I2

I1

VDD

VDD

10

I4

I3

MATCH

GND

ND

NC

I4

I3

GND

WL2

T3

T4

$\overline{BL2}$

BL2

**Fig 4**

Fig 5

Fig 6

Fig 7A

Fig 7B